# EUROPEAN PATENT SPECIFICATION

(11) **EP 1 155 334 B1**
(45) Date of publication and mention of the grant of the patent: **05.02.2003**
(21) Application number: 00914650.7
(22) Date of filing: 22.02.2000
(51) Int. Cl.: G01R 21/133, G01R 13/40

(54) **UTILITY METER WITH DISPLAY DURING POWER INTERRUPTION**
VERBRAUCHSZÄHLER MIT ANZEIGEVORRICHTUNG WÄHREND EINES STROMAUSFALLS
COMPTEUR DE SERVICES COMPORTANT UN AFFICHAGE PENDANT UNE INTERRUPTION DE COURANT

(30) Priority: 26.02.1999 US 258536
(43) Date of publication of application: 21.11.2001
(73) Proprietor: Siemens Power Transmission & Distribution, Inc., Wendel, NC 27591-8309 (US)
(72) Inventor: STENBERG, David, Lebanon, IN 46052 (US); BURNS, Gordon, West Lafayette, IN 47906 (US); CHENG, Kuang-Sheng, White Bear Lake, MN 55127 (US)
(74) Representative: Allen, Derek
(86) International application number: US0004370
(87) International publication number: WO00050906

(56) References cited:
- DE-A- 3 010 878
- DE-A- 3 033 095
- DE-A- 4 404 850
- GB-A- 2 215 850
- US-A- 4 978 911
- US-A- 5 270 949

## Description

### Field of the Invention

The present invention relates generally to the field of metering devices, and in particular, to utility meters.

### Background of the Invention

US Patent 5,270,949 to Atherton et al. refers to a method and apparatus for disposing a meter register in a default mode. The apparatus for disposing a meter register in a default mode of operation includes a microcontroller coupled to a programmable non-volatile memory for automatically disposing the meter register in a self-programmed state when the electrical meter containing the meter register is installed for the first time. The self-programmed state is a functional default state and provides a monitoring utility company with accurate customer billing information from the time of installation. Accordingly, a technician responsible for installing the meter in the field need not be familiar with the techniques for programming the meter. If a mode of operation other than the default mode of operation is preferred, the microcontroller can be accessed for disposing the meter in a time-of-use and demand mode of operation or a demand only mode of operation. The microcontroller also provides means for retaining a programmed state of the meterregister in the event of a power outage. Thus, when power is again supplied to the meter after an outage, the meter register is again disposed in the last programmed state prior to power failure.

US Patent 4,978,911 to Perry et al. refers to an lectrical energy analyzer The electrical energy analyzer including a computer for monitoring energy consumption and supporting ripple control is provided with improved AID converter resolution by applying a 1/2 LSB square wave offset signal to the non-inverting input of a differential amplifier for amplifying a current shunt voltage. The amplifier output has limited filtering to allow a 1/2 to 1 LSB random signal to be applied to the measurement signal entering the A/D converter.

German puplished nonprosecuted application DE 30 33 095 Al refers to an electric consumption meter which generates a pulse-frequency that is dependent on the current flowing through an electrical load, whereby the consuption meter counts the pulses. The consumption meter is coupled to a mains voltage and in addition to a battery, so that in case the mains voltage is lost the battery provides voltage for displaying the counted value of pulses.

Utility meters are devices that. among other things, measure the consumption of a utility generated quantity, such as electrical energy, gas, or water, by a residence, factory, commercial establishment or other such facility. Utilities rely on revenue meters for many purposes, including billing customers and tracking demand for the relevant consumed resource. Utility meters typically include a device that measures the resource consumption, and a device that effectuates display of the a measure of the consumed resource.

For example, a common form of electrical energy utility meter comprises an inductive drive that rotates a spinning disk at an angular velocity proportional to the amount of power being consumed. The spinning disk drives mechanical counters that provided an indication of power consumed over time.

Over recent years, electronic meters have been developed that are replatcing the spinning disk meter design for measuring electrical tnergy consumption. Electronic meters use electronic circuits to measure, quantify and display energy consumption information. In general, electronic meters may be divided into two portions, a sensor portion and a measurement portion. The sensor portion includes primarily analog circuitry in the form of sensor devices that are connected to the electrical system of a facility, and more particularly, to the power lines. The sensor devices generate signals that are indicative of the voltage and current in the power lines. In general, the sensor portion of a revenue meter operates with the high voltages and currents that are present on the power lines.

The measurement portion of an electronic meter includes primarily digital electronics that receive and process the signals generated by the sensor portion to determine watt-hours, volt-amps ("VAs"), reactive volt-amps ("VARs") and other information that quantifies the power consumed by the facility. The digital circuitry typically includes one or more microprocessors. microcontrollers, or digital signal processors, as well as a display for displaying the power consumption information.

The digital circuitry within the measurement portion requires bias power to operate. Such power is often provided by a power supply within the meter. To this end. power supplies within meters are typically AC to DC converters that convert the AC electrical power from the power lines to bias electrical power of about 5-12 volts DC.

One drawback associated with such meters arises in the event of a power outage, or other interruption of the AC electrical power to the power supply. An interruption in the AC electrical power refers to any situation in which the AC electrical power received from the power lines is absent. whether by design or by accident. In the event of an AC power interruption, the digital circuitry within the measurement portion loses the bias power derived from the AC electrical power. If power to the digital circuitry is completely removed, the digital circuitry cannot perform revenue meter functions. Moreover, valuable information stored in memory, including energy consumption information and billing information, may be permanently lost.

To this end, techniques have been developed for writing critical data to a non-volatile memory, such as an electrically erasable programmable read only memory ("EEPROM"), upon detection of an interruption in AC power to the power supply. For example. U.S. Patent No. 4,999,575 to Germer shows a power supply for use in a metering system that saves certain data to non-volatile memory upon detection of a power outage.

Some metering devices further include battery cells that allow portions of the digital circuit to operate in a reduced operational mode during a power outage to allow clocks and other circuits to continue to operate during the power outage. For example, U.S. Patent No. 4,335,447 to Jerrim shows a demand utility meter having a battery for allowing certain clocking and demand recording operations to continue during a power outage.

A problem not addressed by the Jerrim device, and other devices in the prior art, is enabling meter reading during an interruption of AC power to the meter. In particular, in order to conserve battery power during an AC power interruption, metering devices disable the digital display. Because of the high power consumption normally associated with digital displays, disabling the display greatly increases the length of time a battery can provide power to the operations of the digital circuitry.

Because the meter display is inactive during an AC power interruption, and because AC power interruptions are not generally predictable by the utility, there is always a possibility that meter reading personnel from the utility will attempt to read a meter when the AC power to the meter is interrupted. Because the display is disabled during the AC power interruption. the meter reader cannot gather the meter reading data. thereby resulting in wasted effort and time. While AC power interruptions are somewhat infrequent in residential areas, AC power interruptions are more common in rural and other areas in which outbuildings and other uninhabited structures are widely dispersed. In particular, such structures are sometimes configured such that the customer may turn off the power to the facility "upstream" of the meter. which results in an AC electrical power interruption to the meter as well as to the customer structure. Because of the increased probability of power interruption in such areas, and because of the greater expense associated with reading meters in such areas, the inability to obtain meter readings during an AC power interruption to the meter can result in increased costs to the utility provider.

There is a need, therefore, for an electronic meter that allows for meter reading during interruption of external AC power to the meter. There is a further need for such an electronic meter that does not significantly drain the back-up battery power source.

### Summary of the Invention

The present invention overcomes the above stated needs, as well as others, by providing a meter that, while AC power is interrupted to the meter. detects an operator activated display request signal and then causes the display of metering information for a finite time period in response to said display request signal. A back-up power supply provides the power to the display during the power interruption. However, by only operating the display responsive to an operator activated display request signal, the back-up power supply power is conserved.

An exemplary embodiment of the present invention includes an electronic utility meter coupled to an electrical system of a facility. The electronic utility meter includes a source of energy consumption information, a display, a power supply operable to convert AC electrical power from an external power source to bias power and a processor. The processor is coupled to the source of energy consumption information to receive energy consumption information therefrom. The processor is operable to generate metering information based at least in part on said energy consumption information, and provide metering information to the display. The processor is further operable to determine whether the power supply is not receiving electrical power from the external power source, or in other words, whether there is a power interruption. The processor is further operable to detect an operator activated display request signal when the power supply is not receiving AC electrical power from the external power source and cause a display of metering information responsive thereto.

The meter according to the present invention thus provides for causing display of metering information during an AC electrical power operation that does not consume large amounts of power. As a result. the display during the AC electrical power interruption may suitably be powered by a battery. Because the display is only operated responsive to an operator-generated request during the power interruption, the battery power is conserved.

The above discussed features and advantages, as well as others, may readily be ascertained by those of ordinary skill in the art by reference to the following detailed description and accompanying drawings.

### Brief Description of the Drawings

Fig. 1 shows a block diagram of an exemplary electronic utility meter according to the present invention;
Fig. 2 shows a schematic diagram of an exemplary embodiment of power failure detection circuit for use in a meter in accordance with the present invention;
Fig. 3 shows a schematic diagram of an exemplary back-up power supply circuit for use in the meter of Fig. 1;
Fig. 4 shows a flow diagram of an exemplary set of operations of the processor of the meter of Fig. 1.

### Detailed Description

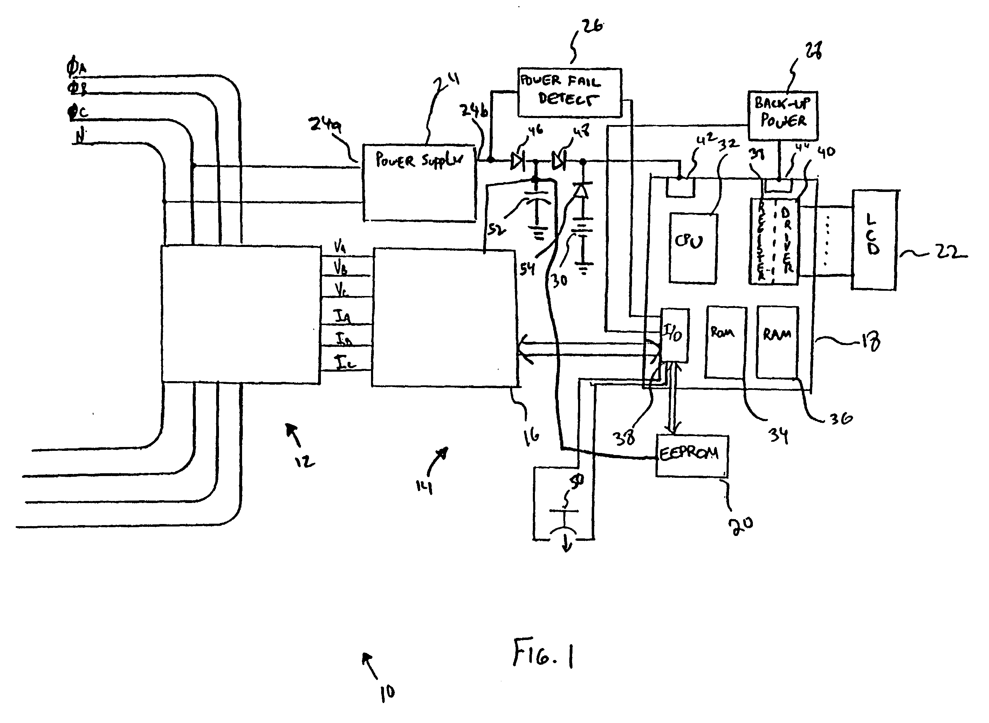

Fig. 1 shows a block diagram of an exemplary electronic utility meter 10 according to the present invention. As discussed in further detail below. electronic utility meter includes an arrangement for providing power to a display during the interruption of AC electrical power to the meter 10.

In general, the meter 10 includes a sensor portion or sensor circuit 12 and a measurement portion or measurement circuit 14. The sensor circuit 12 is operably coupled to a plurality of utility power lines including a phase A power line φA, a phase B power line φB, a phase C power line φC, and a neutral line N. The plurality of utility power lines φA, φB, φC, and N connect to an electrical utility, not shown, and provide power from the utility to a load, not shown, for which power consumption is metered by the meter 10. The load may suitably be the electrical system of a residential facility, industrial facility, commercial facility, or the like.

It is noted that the exemplary embodiment described herein is installed in what is referred to as a three phase power configuration, consisting of three phases of power lines φA, φB, and φC. The present invention, however, is in no way limited to use in any particular power configuration, and those of ordinary skill in the art may readily modify the meter 10 for use in single phase and other power configurations.

Referring again to the exemplary embodiment of Fig. 1, the sensor circuit 12 includes circuitry for generating signals indicative of the power provided to the load on the power lines φA, φB, φC, and N. To this end, the sensor circuit 12 may include a plurality of current sensing devices, such as current transformers, current shunts, embedded coils or the like, which provide output measurement signals IA, IB, and IC that are representative of the current waveform on each of the lines φA, φB, and φC. Likewise, the sensor circuit 12 may further include a plurality of voltage sensing devices, such as voltage divider circuits, which provide output measurement signals VA, VB, and VC that are representative of the voltage waveform on each of the lines φA, φB, and φC.

The measurement circuit 14, in general, is a circuit that is operable to receive the signals representative of the power on the power lines φA, φB, and φC and generate metering information. The metering information is information which, among other things, tracks the amount of power or energy consumed by the load. In the exemplary embodiment described herein, the measurement circuit 14 includes an energy consumption circuit 16, a processor 18, a non-volatile memory 20, and a display device 22. The measurement circuit 14 further includes circuitry for providing bias power to the above described components, including a power supply 24, a power failure detection circuit 26, a first back-up power supply 28, and a second back-up power supply 30.

The energy consumption circuit 16 is a device that is operable to receive the analog measurement signals from the sensor circuit 14 and provide raw energy consumption data, and preferably other data therefrom. The phrase "energy consumption data" as used herein is data that includes information regarding the energy flowing through the lines φA, φB, and φC, and may by way of example consist of digital words representative of values of watts, VA, VAR, watt-hrs, VA-hrs, VAR-hrs, or even constituent values such as Vrms, Irms or power factor information. Such circuits may be integrated into a single integrated circuit package. An example of such a circuit includes the Power Measurement Integrated Circuit found with the Model S-4 Meter available from Siemens Power Transmission & Distribution, LLC, in Lafayette IN. Other examples of such circuits include the digital multiplication and DSP circuit 20 of U.S. patent no. 4,884,021 to Hammond, the digital signal processor 14 of U.S. patent no. 5,059,896, the front end CPU 44 of U.S. patent no. 5,471,137 to Briese et al., and the A/D and DSP 14 of U.S. patent no. 5,544,089 to Hemminger et al., all of which are incorporated herein by reference.

The processor 18 is preferably a microprocessor or microcontroller, that includes a central processing unit ("CPU") 32, a read only memory ("ROM") 34, a random access memory ("RAM") 36, and an input/output ("I/O") device 39. In the exemplary embodiment described herein, the processor 18 includes a display register 38, a display driver 40, a first bias connection 42 and a second bias connection 44.

The processor 18 is configured in a manner well known in the art to obtain energy consumption data and generate metering information therefrom. To this end, the CPU 32, which preferably executes a program stored in the ROM 34, controls the operation of the various devices of the processor 18. In particular, the CPU 32 receives energy consumption data from the energy consumption circuit 16 through the I/O device 39. The CPU 32 then uses the RAM 36 and/or registers internal and external to the CPU 32 to store various values, including interim calculations, in order to carry out processes that generate the metering information. The metering information may include, by way of example, accumulated energy consumption information as well as quantities associated with demand metering and time of use metering.

The display register 38 is a device operable to store metering information to be displayed on the display 22. The display driver 40 is a device that is operable to convert the metering information stored within the display register 38 into a format suitable for the display 22.

Examples of processors that obtain energy consumption information and perform further operations on such data to generate metering display information as well as perform other functions are described in U.S. patents nos. 4,884,021, 5,059,896, 5,471,137 and 5,544,089, discussed above.

The first bias connection 42 is a pin connection to the processor 18 that is coupled to the power supply 24 through first and second protection diodes 46 and 48, respectively. The first bias connection 42 is operably connected to provide the bias power generated by the power supply 24 to a plurality of devices within the processor 18, including but not limited to the CPU 32, the RAM 36, the display register 38, and the display driver 40.

The second bias connection 44 is operably connected to the first back-up power supply 28. The second bias connection 44 is further operably connected to provide bias power from the first back-up power supply 28 to at least the display register 38 and the display driver 40.

In the exemplary embodiment described herein, the display 22 is also operably connected to receive power from either the power supply 24 or the first back-up power supply 28 through the processor 18 and the first and second bias connections 42 and 44 respectively.

In accordance with the present invention, the processor 18 is operably configured to, through suitable programming and/or physical configuration, determine whether the power supply 24 is not receiving electrical power from the external power source. To this end, the I/O device 39 is coupled to receive a power fail signal from the power failure detection circuit 26. The CPU 32 is operable to determine whether the power supply 24 is not receiving electrical power from the external power source based on the power fail signal.

In response to a determination that the power supply 24 is not receiving electrical power, the CPU 32 is operable to enter a low power mode in which the power consumption by the measurement circuit 14 in general is limited. To this end, among other things, the CPU 32 is operable to cause the display 22 not to display metering information except under the conditions specified further below. By disabling the display 22, the power consumption by the measurement circuit 14 is reduced.

The processor 18 is further operable to detect an operator-activated display request signal when said power supply is not receiving AC electrical power from the external power source. To this end, the processor 18, and more specifically, the I/O device 39 is operably connected to a push-button switch 50. When depressed by an operator, the push-button 50 is operable to generate the operator activated display request signal.

The processor 18 is further operable to cause a display of metering information responsive to the detection of the display request signal when the power supply is not receiving AC electrical power from the external power source. Preferably, under such circumstances, the processor 18 is operable to cause the metering information to be displayed for a finite amount of time. In this manner, the processor 18 allows display of metering information during an AC power interruption without consuming a large amount of power. In particular, the display 22 need only operate (and thus consume power) when there is an operator-generated display request signal, and then only for a finite amount of time.

It is noted that the use of the push-button 50 is given by way of example only. Other operator activated mechanisms may be used to generate a display request signal, such as, for example, a reed switch or a card reader.

In any event, the power supply 24 is a circuit that is operable to convert AC electrical power received from an external power source, which in the exemplary embodiment is the phase C power line φC, to a bias voltage, preferably a DC bias voltage. In particular, the power supply may suitably be a switched-mode inverter type power supply that converts the power line AC voltage received at its input 24a to one or more DC bias voltages provided at its output 24b. The power supply input 24a is coupled across the phase C power line φC and the neutral line N, and the power supply output 24b is coupled to the first bias connection 42 of the processor 18 through first and second protection diodes 46 and 48, respectively.

A storage capacitor 52 is coupled between the output of the first protection diode 46 and ground. The storage capacitor 52 is operable to store energy generated by the power supply 24 during normal operation, or in other words, in the absence of an AC power interruption. The storage capacitor is further operable to use the stored energy to provide short-term power to the measurement circuit 14 upon an interruption in AC electrical power. The storage capacitor 52 thereby allows short-term high power consumption immediately following an interruption in AC electrical power.

The second back-up power supply 30 is connected at the output of the second protection diode 48. In the exemplary embodiment described herein, the second back-up power supply 30 includes one or more batteries. The batteries of the power supply 30 are connected to the output of the second protection diode 48 by a diode 54. The second back-up power supply 30 is operable to provide bias power to the processor 18 during a power interruption.

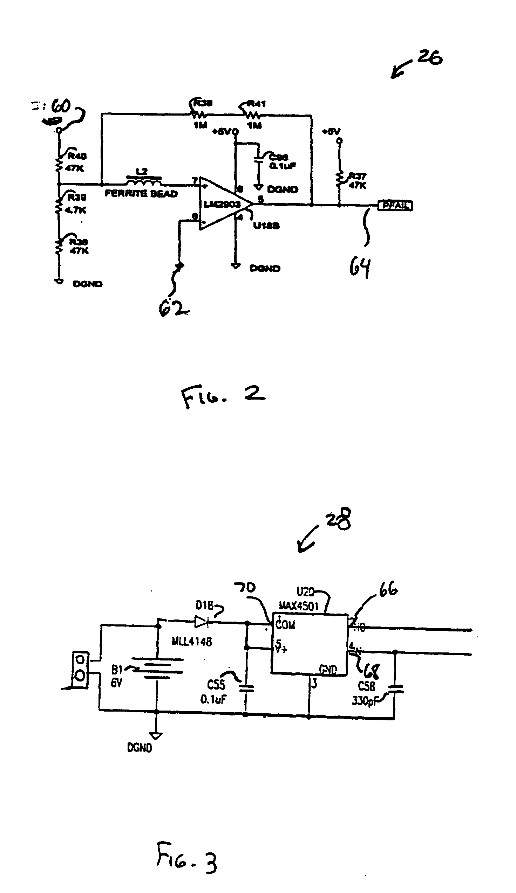

The power failure detection circuit 26 is a device that generates a power fail signal that is representative of whether the AC electrical power to the power supply 24 has been interrupted. In the exemplary embodiment described herein, the power failure detection circuit 26 is connected to the power supply output 24b and to I/O device 39 of the processor 18. Further details regarding an exemplary embodiment of the power failure detection circuit 26 are provided below in connection with Fig. 2.

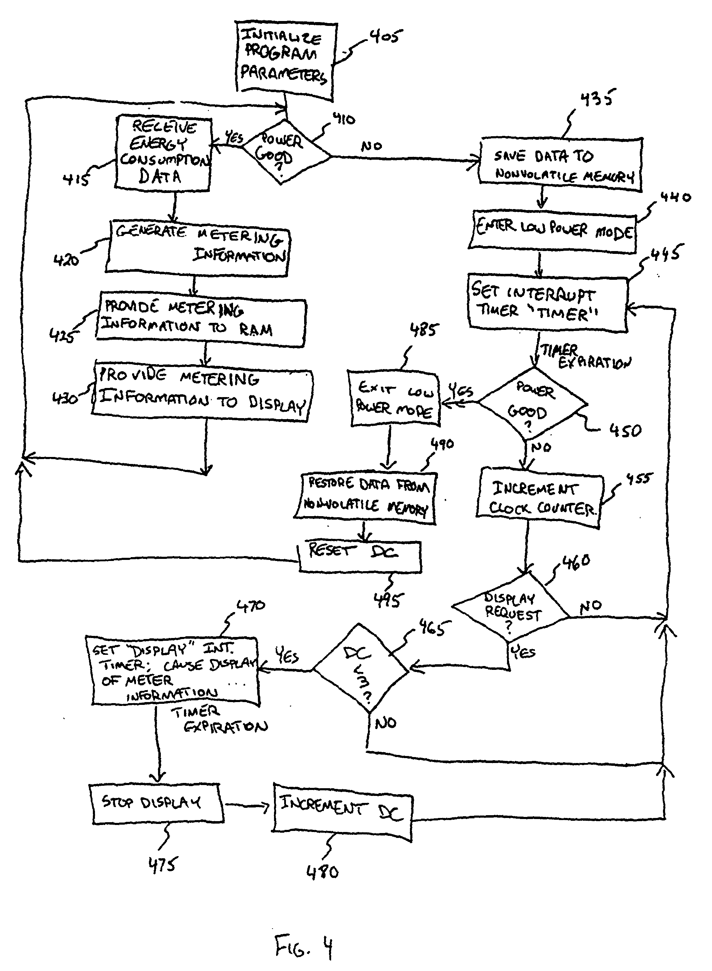

The first back-up power supply 28 is a device that is operable to provide bias power to the display 22, particularly when the AC power to the power supply 24 has been interrupted and the processor 18 has detected an operator-generated display request signal. To this end, the first back-up power supply 28 is coupled to the I/O device 39 to receive a control signal therefrom, and is further operably connected to provide bias power to the second bias connection 44 responsive to receiving the control signal. Further detail regarding an exemplary embodiment of the first back-up power supply 28 is provided below in connection with Fig. 3.

In operation, AC electrical power is provided from the electrical utility to the load through the power lines φA, φB, φC, and N. In general, AC electrical power is often provided in three phases to large industrial and commercial establishments. In any event, the power provided to the load is detected by the sensor circuit 12, which generates measurement signals representative of such power flow. The sensor circuit 12 provides the measurement signals to the energy consumption circuit 16. In particular, the sensor circuit 12 generates the three voltage measurement signals VA. VB, and VC and the three current measurement signals IA, IB, and IC. Each of the three voltage measurement signals is an analog signal that is representative of the voltage waveform on one of the power lines. Each of the three current measurement signals is an analog signal that is representative of the current waveform on one of the power lines.

The energy consumption circuit 16 then generates energy consumption data or information based on the measurement signals. For example, the energy consumption circuit 16 may generate digital signals that include energy consumption information relating to watts, VAs, VARs, watt-hrs, VA-hrs, VAR-hr, or component signals thereof.

To provide power for the operation of the energy consumption circuit 16. the processor 18 and the LCD 22, the power supply 24 converts AC electrical power received from the φC power line to bias power in the form of a DC voltage.

In the exemplary embodiment described herein, the power supply 24 generates a regulated output voltage of approximately 5.7 volts DC at its output 24b. The regulated output voltage passes through the isolation diode 46 to charge the capacitor 52 to approximately 5.0 volts DC. The regulated output voltage then passes through the isolation diode 48 to provide a 4.3 volt bias voltage at the first bias connection 42 of the processor 18. The bias voltage to the energy consumption circuit 16 and the non-volatile memory 20 is tapped off between the first and second isolation diodes 46 and 48. respectively.

The power failure detection circuit 26 also receives the bias voltage from the output 24b and provides a power failure detection signal indicative of the presence of AC electrical power at the power supply 24 to the processor 18. In other words, in the absence of an AC electrical power interruption, the power failure detection circuit 26 provides information to the processor 18 indicating to the processor that the power supply 24 is generating a good bias voltage. Such a power signal could be a logical high signal or a logical low signal. Further detail regarding the operation of an exemplary power failure detection circuit 26 is provided below in connection with Fig. 2.

Referring again to the energy measurement operation, the energy consumption circuit 16 provides the energy consumption information to the processor 18 through the I/O device 39. The processor 18 then performs a number of functions using the energy consumption information in order to generate metering information.

Metering information may include accumulated energy consumption information in standardized units, time of use metering information, demand metering information, and other information normally generated in electronic meters. For example, the processor 18, and in particular, the CPU 32, accumulates energy consumption in standard units for one or more of watt-hrs. VA-hrs, and VAR-hrs. The metering information is stored locally in the RAM 36, or alternatively, in registers internal to the CPU 32.

The CPU 32 also causes the display of at least some of the generated metering information. The CPU 32 may, for example, cause display of the accumulated energy consumption in standard units. To this end, the CPU 32 provides a select value of the metering information, such as accumulated energy consumption information, to the display register 38. The select value of the meter information is then provided to the display 22 via the display driver 40.

The CPU 32 may suitably cause a plurality of values of the metering information to be displayed in sequence. The sequence may be preprogrammed into the meter 10 by the user as is known in the art. The CPU 32 may suitably store a duplicate version of any metering information.

In the event of an AC power interruption to the power supply 24, or in other words, if there is a power outage on the power line φC, then the voltage level at the output 24b of the power supply 24 begins to drop. In response to the drop in the voltage level at the output 24b, the power failure detection circuit 26 provides a power fail signal to the I/O device 39 of the processor 18 indicative of the interruption of the AC electrical power.

As the bias voltage at the output 24b drops below the voltage at the capacitor 52, the capacitor 52 begins to discharge, thereby temporarily providing bias power to both the processor 18 and the energy consumption circuit 16. At about the same time, the CPU 32 receives the power fail signal from the I/O device 39 and enters a low power mode of operation responsive thereto. Prior to entering the low power mode of operation, the CPU 32 causes critical data in its registers and/or in the RAM 36 to be written to the non-volatile memory 20, which may suitably be an EEPROM. Because the bias power to the non-volatile memory 20 is tapped from between the two isolation diodes 46 and 48, the non-volatile memory 20 derives its bias power from the discharging capacitor 52. The "critical data" that is written to the non-volatile memory 20 may include the accumulated energy consumption information and a time stamp of the power interruption.

The CPU 32 further causes the LCD 22 to be disconnected from the first bias connection 42. As a result, the LCD 22 no longer receives power from any of the devices connected to the first bias connection 42. Likewise, the CPU 32 disconnects the display register 38 and the display driver 40 from the first bias connection.

In further detail, it is noted that many microprocessors that include display drivers, such as the NEC78064 processor, available from NEC, Santa Clara, California, allow internal display circuitry to be powered either from the main bias power connection (*i.e*., the first bias connection 42), or an auxiliary display bias power connection (*i.e*., the second bias connection 44). Moreover, such microprocessors may further allow display circuitry within the microprocessor to provide the power to the display itself, which is packaged separately. As a result, such a microprocessor used as the processor 18 would disconnect the display 22, the display register 38 and the display driver 40 from the main bias power by internally switching the bias power connection to those circuits to the second bias connection 44. It will be noted however, that the bias power switching capabilities discussed above may readily be carried out when the processor does not have such internal capabilities, through the use of discrete external switching devices.

In any event, after the capacitor 52 discharges to below 3.8 volts, the second back-up power supply 30 begins to provide bias power to the processor through the first bias connection 42. The second isolation diode 48 prevents energy consumption circuit 16 and the non-volatile memory 20 from loading down the second back-up power supply 30. In addition, the processor 18 now operates under low power mode, thereby reducing the power consumption on the second back-up power supply 30.

In the low power mode, the processor 18 may suitably operate using a low speed clock to conserve power. Finally, the load on the second back-up power supply 30 is further reduced because the display 22, the display register 38, and the display driver 40 have been decoupled from the first bias connection 42, as discussed above.

During low power mode, the processor 18 performs minimal housekeeping functions and otherwise periodically checks for the presence of a operator generated display request signal. To this end, the CPU 32 determines whether the I/O device 39 shows that the push-button 50 has been depressed. If the push-button 50 has been depressed, then the processor 18 causes the metering information to be displayed on the display 22.

To this end, the processor 18 causes power to be provided to the display 22 and further causes the metering information in the RAM 36 to be provided to the display 22. In particular, the CPU 32 first causes the I/O device 39 to provide a control signal to the first back-up power supply 28. The control signal causes the back-up power supply 28 to provide a bias voltage to the second bias connection 44. As a result, the bias voltage from the back-up power supply 28 provides bias power to the display register 38, the display driver 40, and the display 22. Then, the CPU 32 causes the metering information to be copied from the RAM 36 to the display register 38 and thereafter displayed on the display 22.

After a finite amount of time, the CPU 32 causes the first back-up power supply 28 to stop providing bias voltage to the second bias connection 44. As a result, the bias voltage to the display register 38, the display driver 40, and the display 22 is again removed, thereby conserving energy.

The CPU 32 then continues to periodically monitor the status of the push-button 50 for further display request signals.

When AC electrical power is restored, then the power supply 24 again produces the DC bias voltage of approximately 5,7 volts at the output 24b. The DC bias voltage from the power supply 24 then provides a voltage at the first bias connection 42 that exceeds the voltage from second back-up power supply 30. As a result, the voltage generated by the second back-up power supply 30 does not propagate through the diode 54, thereby effectively disconnecting the second back-up power supply 30.

As the DC bias voltage at the output 24b increases, the power failure detection circuit 26 provides a power fail signal indicative of the presence of AC electrical power to the I/O device 39. The CPU 32 obtains the power fail signal indicative of the presence of AC electrical power, or in other words, the end of the power interruption, and restores operations to normal metering operations as described further above.

Moreover, the bias voltage produced by the power supply 24 provides power to the non-volatile memory 20 and the power consumption circuit 16. The CPU 32 furthermore causes the display register 38, the display driver 40, and the display 22 to again obtain bias power from the first bias connection 42. or in other words, the power supply 24.

As a result, the meter 10 of the present invention, and the arrangement for displaying meter information in the event of a power interruption, allows for display of metering information even when the AC power to the meter has been interrupted. Moreover, such display is accomplished without unduly loading the back-up power supplies, which typically derive energy from battery cells, by only displaying the metering information upon receipt of an operator generated display request signal, and even then only for a finite amount of time.

Fig. 2 shows in further detail an exemplary embodiment of the power failure detection circuit 26 of Fig. 1. In general, the power failure detection circuit includes a comparator, or operation amplifier U18B, having a first differential input connected through a ferrite bead L2 to a voltage divider formed by an input resistor R40 and two dividing resistors R36 and R38. A second differential input of the operational amplifier U18B is coupled to a reference voltage input 62. A pair of feedback resistors R38 and R41 connect the output 64 of the operational amplifier U18B to the first differential input. An input 60 to the voltage divider is connected to the input resistor R40.

The input 60 is preferably coupled to the output 24b (see Fig. 1) through a diode or other device, not shown, that reduces the voltage at the input 60 to 5.0 volts during normal operation. The reference voltage input 62 is preferably coupled to a source of 2.5 volts that can remain stable (at least temporarily) upon an interruption of AC electrical power to the power supply 24 of Fig. 1. For example, the output of the capacitor 52 of Fig. 1 may suitably be configured to provide a stable 2.5 volt stable reference point.

In operation, when the input voltage at the input 60 is approximately 5 volts, the voltage divider formed by the resistors R36, R39 and R40 produce a divided voltage slightly in excess of the reference voltage. To this end, the input resistor R40 may suitable have a resistance of 47KΩ while the dividing resistors R36 and R39 have a combined resistance of 51.7KΩ.

Thus, the voltage on the first differential input of the operational amplifier U18B exceeds the 2.5 reference voltage that is present on the second differential input of the operation amplifier U18B. As a result, the operational amplifier provides approximately 5 volts high logic output at its output 64. Accordingly, the power failure detection circuit 26 of Fig. 2 provides a logic high voltage when AC electrical is *not interrupted.*

Upon interruption of the AC electrical power to the power supply 24 of Fig. 1, the voltage at the input 60 will drop. Once the voltage drops below a certain point, approximately 4.7 volts, the voltage produced by the voltage divider at the first differential input of the operational amplifier U18B will fall below 2.5 volts. As a result, the 2.5 volt reference voltage on the second differential input will exceed the voltage on the first differential input of the operation amplifier U18B. Accordingly, the voltage at the output 64 will drop to zero. or a low logic voltage. Thus, the power failure detection circuit 26 of Fig. 2 provides a low logic voltage or zero volts when AC electrical power to the power supply 24 of Fig. 1 is interrupted.

The feedback resistors R38 and R41 provide some hysteresis such that the threshold to change the power fail signal from the low logic level to the high logic level is slightly higher than the threshold to change the power fail signal from the high logic level to the low logic level. Moreover, the ferrite bead L2 prevents spurious transients from changing the state of the power failure signal. The hysteresis and the ferrite bead L2 help inhibit false or spurious state changes in the power fail signal generated by the power failure detection circuit 26. Such inhibition of spurious state changes in the power fail signal is important because the processor 18 of Fig. 1, as discussed above, performs significant changes in its operation based on any detected change in the power fail signal.

It will be noted that the circuit in Fig. 2 is given by way of example only, and that those of ordinary skill in the art may readily devise other implementations of a circuit that detects the output of the power supply 24 of Fig. 1 and provides a signal indicative of the condition of the output that corresponds to the presence or lack of AC electrical power at the input 24a of the power supply.

Moreover, still other power failure detection circuits may obtain information directly from one or more of the AC power lines themselves, or from one of the voltage measurement signals from the sensor circuit 12 of Fig. 1. For example, such an alternative power failure detection circuit would include a device that provides a pulse output having a pulse width that is representative of the magnitude of the voltage on the power lines. Such devices are well known, and may include a comparator. The pulse output would then constitute the power fail signal that is provided to the processor 18. In such a case, the processor 18 would perform an operation that determines whether the pulse width of the power fail detection signal is consistent with the presence of AC electrical power or an interruption in AC electrical power.

In any event, the power failure detection circuit 26 need only provide a signal that is indicative of an interruption of AC electrical power to the processor 18. Those of ordinary skill in the art may readily configure such a power failure detection circuit to suit their own implementation needs.

Fig. 3 shows a schematic circuit diagram of an exemplary embodiment of the first back-up power supply 28 of Fig. 1. In pertinent part. the first back-up power supply comprises at least one battery B1 and a low leakage isolation switch U20. The switch U20 may suitably be a MAX4501 integrated circuit switch available from Maxim, of Sunnyvale, California. The battery B1 is connected to the switched input 70 of the switch U20 through a diode D18. The control input 68 of the switch U20 is connected to the I/O device 39 of the processor 18 (See Fig. 1). The bias voltage output 66 of the switch U20 is connected to the second bias connection 44 of the processor 18 (See Fig. 1).

In operation, when the control input 68 receives a control signal from the processor 18 (Fig. 1) requesting operation of the first back-up power supply 28, such as upon detection of a display request signal during an AC power interruption, then the switch U20 causes the switched input 70 to be coupled to the bias voltage output 66. As a result, the battery B1 is coupled to provide bias power to the second bias connection 44 of Fig. 1.

When no control signal is provided by the processor 18 (Fig. 1) to the control input 68. the switch U20 causes the switched input 70 to be disconnected from the bias voltage output 66. As a result, the battery B1 does not provide bias power to the second bias connection 44 of the processor 18 (See Fig. 1).

Fig. 4 shows a flow diagram of an exemplary set of operations of a processor, such as the processor 18, that may be used in a meter according to the present invention. In particular, the operations shown in Fig. 4 and described below may suitably be carried out by the processor 18 of Fig. 1. but may in any event be carried out by a processor that is part of any meter that includes, among other things, a power supply that receives AC electrical power from an external source, a source of energy consumption information. and a display.

The flow diagram includes the operations of the processor 18 in normal metering operations as well as operations relating to display during power outage. Normal metering operations of the processor 18, such as those that relate to performing metering calculations, are highly generalized and are only illustrated to place the operations relating to display during power outage in context.

Step 405 illustrates the first step, which is executed upon initial power up of the meter 10. The initial power up may occur when the meter 10 is first connected to the power lines φA, φB, φC, and N. In step 405, the CPU 32 initializes program parameters and performs other start-up operations. Thereafter, in step 410, the CPU 32 determines whether the AC electrical power is present. To this end, the processor 18 receives the power fail signal from the power failure detection circuit 26 through the I/O device 39. The CPU 32 then determines whether the power fail signal indicates that AC electrical power is present.

If, in step 410, the CPU 32 determines that AC electrical power is present, the CPU 32 proceeds to execute step 415. In step 415, the CPU 32 receives the energy consumption data through the I/O device 39. Thereafter, in step 420, the CPU 32 generates metering information. To this end, the CPU 32 may convert the raw energy consumption data received from the energy consumption circuit 16 to standardized units for storage and display. Such operations are well known. The CPU 32 may in any event generate metering information including, but not limited to, watt-hrs, VA-hrs, VAR-hrs, RMS voltage and current information. The CPU 32 may of course generate standard metering quantities that are not necessarily displayed.

Once the metering information is generated in step 420, the CPU 32 provides the metering information to the RAM 36 in step 425. The CPU 32 further provides at least some of the metering information to the display register 38 in step 430. The CPU 32 then returns to step 410 and proceeds accordingly. The flow of steps 415 through 430 illustrate the "normal" operations of the CPU 32 when AC electrical power is present. It will he noted that the CPU 32 may suitably perform several other functions during "normal" operations, which are not central to the operation of the present invention, and therefore are omitted for purposes of clarity of exposition.

In any event, if the CPU 32 determines in the execution of the step 410 that the AC electrical power has been interrupted, then the CPU 32 proceeds to step 435. In step 435, the CPU 32 transfers certain critical data to the non-volatile memory 20. In particular, certain of the metering information must be preserved through the power outage and even in the event that the back-up power supplies fail. Such information often will include the accumulated watt-hr consumption information as well as time stamp information. In any event, the CPU 32 transfers such information from its internal registers, or from other registers or the RAM 36 to the non-volatile memory 20.

Thereafter, in step 440, the CPU 32 enters low power mode. In low power mode, the CPU 32 clock speed is reduced as is well known in the art, and the CPU 32 causes the display register 38, display driver 40 and the display to be disconnected from the bias power received at the first bias connection 42.

Then, in step 445, the CPU 32 sets and interrupt timer TIMER. Until the expiration of TIMER, the CPU 32 does not perform other functions, thereby conserving power. Upon expiration of TIMER, the CPU 32 in step 450 determines whether the power fail signal received by the I/O device 39 indicates that AC electrical power has been restored. If not, then the CPU 32 in step 455 increments a clock counter within the processor 18. The clock counter tracks the time during the AC electrical power interruption. The clock counter may suitably be stored in the RAM 36.

Once the clock counter is incremented, the CPU 32 in step 460 detects whether there is an operator-generated display request signal, as discussed above in connection with Fig. 1. If not, then the CPU 32 returns to step 445 and resets TIMER. If, however, the CPU 32 detects an operator-generated display request signal, then the CPU 32 proceeds to step 465.

In step 465, the CPU 32 first determines whether a display counter DC is less than three. The counter DC tracks the number of times during an AC power interruption that a display request signal has been received. If the CPU 32 determines that DC is *not* less than three, then the CPU 32 returns to step 445 without causing activation of the display. Accordingly, the meter 10 will only honor or respond to up to three display requests during a single AC power interruption.

If, however, in step 465, the CPU determines that the DC is less than three, then the CPU 32 proceeds to step 470. In step 470, the CPU 32 sets an interrupt timer DISPLAY. Before expiration of the timer, the CPU 32 causes the display of the metering information on the display 22. To this end, the CPU 32 sets the interrupt DISPLAY to a finite amount of time that will permit a sufficient time to display the metering information yet avoid excessive consumption of power. For example, the timer DISPLAY may be set to 128 seconds.

While the timer DISPLAY is not expired, the CPU 32 causes bias power to be provided to the display 22, as well as the display register 38 and the display driver 40. To this end, the CPU 32 provides the control signal to the first back-up power supply 28 through the I/O device 39. The first back-up power supply 28 then. as discussed above, provides bias power to the second bias connection 44 and thus the display circuitry in response to the control signal. The CPU 32 then causes the metering information to be displayed on the display 22, as discussed above in connection with Fig. 1.

It will be noted that a first select set of metering information may be displayed during normal operation as discussed above in connection with step 430, and a second select set of metering information may be displayed during an AC power interruption, as discussed above in connection with step 470. The first select set of metering information may suitably be the same as, or different from, the second select set of metering information. The portions of the generated metering information that make up the first and second select sets of metering information to be displayed may suitably be user-programmed.

Upon expiration of the timer DISPLAY, the CPU 32 in step 475 causes the bias power to the display 22, as well as the display register 38 and the display driver 40, to be removed. To this end, the CPU 32 stops providing the control signal to the first back-up power supply 28.

Thereafter, in step 480, the CPU 32 increments DC and then returns to step 445 to reset the interrupt timer TIMER. The CPU 32 remains in the loop of steps 445 through 480 as described above until AC electrical power is restored.

Accordingly, if the CPU 32 determines that the AC electrical power has been restored during the execution of step 450, then the CPU 32 executes step 485. In step 485. the CPU 32 exits low power mode. In particular, the CPU 32 may suitably switch to the higher speed clock used for the "normal" metering operations. In addition, the CPU 32 causes the display register 38, the display driver 40, and the display 22 to be reconnected to the first bias connection 42 to receive bias power therefrom.

Thereafter, in step 490, the CPU 32 restores the data stored in non-volatile memory 20 to the registers and other locations in which the data is stored during "normal" operations of the meter 10. After step 490, the CPU 32 resets the counter DC and then returns to step 410. From step 410, the CPU 32 operates as described above.

There are therefore a plurality of advantages of the present invention arising from the ability to display meter information during an AC power interruption and other features described herein. It will be noted that alternative embodiments of the present invention may not include all of the features described herein yet still benefit from at least some of the advantages of the invention. Those of ordinary skill in the art may readily devise their own such implementations that incorporate one or more of the features of the present invention and fall within the spirit and scope thereof.

It is noted that in one alternative embodiment, a single back-up power supply may provide the functions of both the first back-up power supply 28 and the second back-up power supply 30 of the above described embodiment. For example, the second back-up power supply 30 as configured in Fig. 1 could serve as the only back-up power supply. To this end, the processor 18 would only have to be modified to connect the display 22 (and the display register 38 and the display driver 40) to the first bias connection 42 upon detection of a display request signal during a power interruption. Then, after causing display of the metering information for a finite amount of time, processor 18 would again disconnect the display 22 (and the display circuitry) from the first bias connection.

Such an embodiment may reduce cost in materials by requiring less battery cells and eliminating the other first back-up power supply circuitry. However, using two separate back-up power supplies prevents over-use of the display during power outage operation from draining the power source to the processor, which performs arguably more critical functions during the power outage. Those of ordinary skill in the art may readily determine which approach suits their criteria.

It will further be noted that the above described arrangement for providing an electronic display of consumption information during an AC electrical power interruption may readily be incorporated into other types of electronic utility meters, including gas, water or other utility meters. Such utility meters would typically include a source of resource consumption data or information and a processor for generating metering information for display. For example, an electronic gas meter may include a source of gas consumption information and a processor for generating metering information based on the gas consumption information. Those of ordinary skill in the art may readily incorporate an arrangement as described above for allowing display of the metering information during an AC power interruption.

## Claims

1. An electronic utility meter (10) coupled to an electrical system of a facility, the electronic utility meter (10) comprising:
a) a source of energy consumption information (16);
b) a display (22);
c) a power supply (24) operable to convert AC electrical power received from an external power source to bias power;
d) a processor (18) coupled to the source of energy consumption information (16) to receive energy consumption information therefrom, said processor (18) operable to
generate metering information based at least in part on said energy consumption information;
cause a display of a first set of said metering information when said power supply (24) is receiving AC electrical power from the external power source:
determine whether the power supply (24) is not receiving AC electrical power from the external power source;
detect an operator activated display request signal when said power supply (24) is not receiving AC electrical power from the external power source; and
cause a display of a second set of said metering information responsive to the detection of said display request signal when said power supply (24) is not receiving AC electrical power from the external power source.

2. The electronic utility meter (10) of claim 1 wherein the power supply (24) is operable to convert AC electrical power received from the external power source to bias power, the external power source being the electrical system.

3. The electronic utility meter (10) of claim 1 further comprising a first backup power supply (28) operable to provide bias power to the display (22), and wherein the processor (18) is further operable to cause the back-up power supply (28) to provide bias power to the display (22) responsive to the detection of said display request signal when said power supply (24) is not receiving AC electrical power from the external power source.

4. The electronic utility meter (10) of claim 3 further comprising a second back-up power supply (30) operable to provide bias power to the processor (18) when said power supply (24) is not receiving AC electrical power from the external power source.

5. The electronic utility meter (10) of claim 4 wherein the second back-up power supply (30) includes a source of electrical power internal to the electronic utility meter (10).

6. The electronic utility meter (10) of claim 5 wherein the source of electrical power (30) comprises at least one battery.

7. The electronic utility meter (10) of claim 3 wherein the first back-up power supply (28) includes a source of electrical power internal to the electronic utility meter (10).

8. The electronic utility meter (10) of claim 7 wherein the source of electrical power (28) comprises at least one battery.

9. The electronic utility meter (10) of claim 1 further comprising a push-button (50) coupled to said processor (18), and wherein the push-button (50) is operable to generate said display request signal.

10. The electronic utility meter (10) of claim 1 further comprising a power failure detection circuit (26) operable to provide a power fail signal indicative of an interruption of AC electrical power to the power supply (24), and wherein said processor (18) is further operable to determine when the power supply (24) is not receiving AC electrical power from the external source responsive to the power fail signal.

11. Method of operating an electronic utility meter (10) that includes a power supply (24) that converts AC electrical power received from an external source to bias power, whereby when said power supply (24) is receiving AC electrical power from the external power source a first set of metering information is displayed and during an interruption in the AC electrical power comprising the following steps:
a) receiving power consumption information at a processor (18) and generating metering information therefrom;
b) determining whether the power supply (24) is not receiving AC electrical power from the external source;
c) detecting an operator-generated display request signal when the power supply (24) is not receiving AC electrical power from the external source; and
d) causing a meter display (22) to display at least some of said metering information responsive to detecting the display request signal when the power supply (24) is not receiving AC electrical power from the external source.

12. The method of claim 11 wherein step b) further comprises comparing an output of the power supply (24) with an internal reference voltage, and determining whether the power supply (24) is not receiving AC electrical power from the external source based on said comparison.

13. The method of claim 11 wherein step c) further comprises detecting an operator-generated display request signal by detecting the state of a pushbutton (50) located on the electronic utility meter (10).

14. The method of claim 11 wherein the electronic utility meter (10) further includes a first back-up power supply (28) and wherein step d) further comprises causing the first back-up power supply (28) provide bias power to the display (22) responsive to the detection of said display request signal when said power supply (24) is not receiving AC electrical power from the external power source.

15. The method of claim 14 further comprising a step of employing a second back-up power supply (30) to provide bias power to the processor (18) when said power supply (24) is not receiving AC electrical power from the external power source.

16. The method of claim 14 further comprising a step of employing a battery to provide bias power to the processor (18) when said power supply (24) is not receiving AC electrical power from the external power source.

17. The method of claim 11 wherein the electronic utility meter (10) further includes a battery and wherein step d) further comprises causing the battery to be connected to the display (22) responsive to the detection of said display request signal when said power supply (24) is not receiving AC electrical power from the external power source.

18. An arrangement for displaying information in an electronic utility meter (10) coupled to an electrical system of a facility, the arrangement comprising:
a) a power supply (24) operable to convert AC electrical power received from an external power source to bias power;
b) a display (22) operably coupled to receive bias power from the power supply (24);
c) a first back-up power supply (28) operable to generate bias power;
d) a processor (18) operable to provide bias power to the display (22) when said power supply (24) is receiving AC electrical power from the external power supply (24) and to
determine whether the power supply (24) is not receiving AC electrical power from the external power source;
detect an operator activated display request signal when said power supply (24) is not receiving AC electrical power from the external power source; and
cause the back-up power supply (28) to provide bias power to the display (22) responsive to detecting the operator activated display request signal when said power supply (24) is not receiving AC electrical power from the external power source.

19. The arrangement of claim 18 wherein the processor (18) is further operable to cause the first back-up power supply (28) not to provide bias power to the display (22) when said power supply (24) is receiving AC electrical power from the external power source.

20. The arrangement of claim 18 wherein the power supply (24) is operable to convert AC electrical power received from the external power source to bias power, the external power source being the electrical system.

21. The arrangement of claim 18 further comprising a second back-up power supply (30) operable to provide bias power to the processor (18) when said power supply (24) is not receiving AC electrical power from the external power source.

22. The arrangement of claim 21 wherein the second back-up power supply (24) includes a source of electrical power internal to the electronic utility meter (10).

23. The arrangement of claim 22 wherein the source of electrical power comprises at least one battery.

24. The arrangement of claim 18 wherein the fist back-up power supply (28) includes a source of electrical power internal to the electronic utility meter (10).

25. The arrangement of claim 24 wherein the source of electrical power comprises at least one battery.

26. The arrangement of claim 18 further comprising a push-button (50) coupled to said processor (18), and wherein the push-button (50) is operable to generate said display request signal.

27. The arrangement of claim 18 further comprising a power failure detection circuit (26) operable to provide a power fail signal indicative of an interruption of AC electrical power to the power supply (24), and wherein said processor (18) is further operable to determine when the power supply (24) is not receiving AC electrical power from the external source responsive to the power fail signal.

28. An electronic utility meter (10) coupled to an electrical system of a facility, the electronic utility meter (10) comprising:
a) a source of energy consumption information (16);
b) a display (22);
c) a power supply (24) operable to convert AC electrical power received from an external power source to bias power;
d) a processor (18) coupled to the source of energy consumption information (16) to receive resource consumption information therefrom, said processor (18) operable to
generate metering information based at least in part on said resource consumption information;
cause a display of a first set of said metering information when said power supply (24) is receiving AC electrical power from the external power source:
determine whether the power supply (24) is not receiving AC electrical power from the external power source;
detect an operator activated display request signal when said power supply (24) is not receiving AC electrical power from the external power source; and
cause a display of a second set of said metering information responsive to the detection of said display request signal when said power supply (24) is not receiving AC electrical power from the external power source.

29. The electronic utility meter (10) of claim 28 wherein the source of resource consumption information includes a source of energy consumption information (16), and wherein the metering information includes accumulated energy consumption information.

## Patentansprüche

1. An ein elektrisches System einer Einrichtung angekoppelter elektronischer Verbrauchszähler (10) mit folgendem:
a) einer Quelle von Energieverbrauchsinformationen (16);
b) einer Anzeige (22);
c) einer Stromversorgung (24) zum Umwandeln von von einer externen Stromquelle empfangenem elektrischen Wechselstrom in Vorstrom;
d) einem an die Quelle von Energieverbrauchsinformationen (16) zum Empfangen von Energieverbrauchsinformationen von dieser angekoppelten Prozessor (18) zum
Erzeugen von Zählerstandsinformationen zumindest teilweise auf Grundlage der Energieverbrauchsinformationen;
Bewirken einer Anzeige einer ersten Menge von Zählerstandsinformationen, wenn die Stromversorgung (24) elektrischen Wechselstrom von der externen Stromquelle empfängt;
Feststellen, ob die Stromversorgung (24) keinen elektrischen Wechselstrom von der externen Stromquelle empfängt;
Erkennen eines vom Bediener aktivierten Anzeigeanforderungssignals, wenn die Stromversorgung (24) keinen elektrischen Wechselstrom von der externen Stromquelle empfängt; und
Bewirken einer Anzeige einer zweiten Menge der Zählerstandsinformationen als Reaktion auf die Erkennung des Anzeigeanforderungssignals, wenn die Stromversorgung (24) keinen elektrischen Wechselstrom von der externen Stromquelle empfängt.

2. Elektronischer Verbrauchszähler (10) nach Anspruch 1, wobei die Stromversorgung (24) die Umwandlung von von der externen Stromquelle empfangenem elektrischen Wechselstrom in Vorstrom bewirken kann, wobei die externe Stromquelle das Stromnetz ist.

3. Elektronischer Verbrauchszähler (10) nach Anspruch 1, weiterhin mit einer ersten Reservestromversorgung (28) zur Bereitstellung von Vorstrom für die Anzeige (22), und wobei der Prozessor (18) weiterhin bewirken kann, daß die Reservestromversorgung (28) als Reaktion auf die Erkennung des Anzeigeanforderungssignals Vorstrom für die Anzeige (22) bereitstellt, wenn die Stromversorgung (24) keinen elektrischen Wechselstrom von der externen Stromquelle empfängt.

4. Elektronischer Verbrauchszähler (10) nach Anspruch 3, weiterhin mit einer zweiten Reservestromversorgung (30) zur Bereitstellung von Vorstrom für den Prozessor (18), wenn die Stromversorgung (24) keinen elektrischen Wechselstrom von der externen Stromquelle empfängt.

5. Elektronischer Verbrauchszähler (10) nach Anspruch 4, wobei die zweite Reservestromversorgung (30) eine elektrische Stromquelle innerhalb des elektronischen Verbrauchszählers (10) enthält.

6. Elektronischer Verbrauchszähler (10) nach Anspruch 5, wobei die elektrische Stromquelle (30) mindestens eine Batterie umfaßt.

7. Elektronischer Verbrauchszähler (10) nach Anspruch 3, wobei die erste Reservestromversorgung (28) eine elektrische Stromquelle innerhalb des elektronischen Verbrauchszählers (10) umfaßt.

8. Elektronischer Verbrauchszähler (10) nach Anspruch 7, wobei die elektrische Stromquelle (28) mindestens eine Batterie umfaßt.

9. Elektronischer Verbrauchszähler (10) nach Anspruch 1, weiterhin mit einem an den Prozessor (18) angekoppelten Druckknopf (50) zur Erzeugung des Anzeigeanforderungssignals.

10. Elektronischer Verbrauchszähler (10) nach Anspruch 1, weiterhin mit einer Stromausfallerkennungsschaltung (26) zur Bereitstellung eines eine Unterbrechung des elektrischen Wechselstroms zur Stromversorgung (24) anzeigenden Stromausfallsignals, wobei der Prozessor (18) weiterhin als Reaktion auf das Stromausfallsignal feststellen kann, wann die Stromversorgung (24) keinen elektrischen Wechselstrom von der externen Quelle empfängt.

11. Verfahren zum Betreiben eines elektronischen Verbrauchszählers (10), der eine Stromversorgung (24) enthält, die von einer externen Quelle empfangenen elektrischen Wechselstrom in Vorstrom umwandelt, wobei, wenn die Stromversorgung (24) elektrischen Wechselstrom von der externen Stromquelle empfängt, eine erste Menge von Zählerstandsinformationen angezeigt wird, wobei das Verfahren während einer Unterbrechung des elektrischen Wechselstroms folgende Schritte umfaßt:
a) Empfangen von Stromverbrauchsinformationen an einem Prozessor (18) und Erzeugen von Zählerstandsinformationen daraus;
b) Feststellen, ob die Stromversorgung (24) keinen elektrischen Wechselstrom von der externen Quelle empfängt;
c) Erkennen eines vom Bediener erzeugten Anzeigeanforderungssignals, wenn die Stromversorgung (24) keinen elektrischen Wechselstrom von der externen Quelle empfängt; und
d) Bewirken, daß eine Zähleranzeige (22) als Reaktion auf die Erkennung des Anzeigeanforderungssignals, wenn die Stromversorgung (24) keinen elektrischen Wechselstrom von der externen Quelle empfängt, mindestens einige der Zählerstandsinformationen anzeigt.

12. Verfahren nach Anspruch 11, wobei Schritt b) weiterhin das Vergleichen einer Ausgabe der Stromversorgung (24) mit einer internen Bezugsspannung und auf Grundlage dieses Vergleichs das Feststellen, ob die Stromversorgung (24) keinen elektrischen Wechselstrom von der externen Quelle empfängt, umfaßt.

13. Verfahren nach Anspruch 11, wobei Schritt c) weiterhin das Erkennen eines vom Bediener erzeugten Anzeigeanforderungssignals durch Erkennen des Zustandes eines sich am elektronischen Verbrauchszähler (10) befindenden Druckknopfes (50) umfaßt.

14. Verfahren nach Anspruch 11, wobei der elektronische Verbrauchszähler (10) weiterhin eine erste Reservestromversorgung (28) enthält und der Schritt d) weiterhin das Bewirken, daß die erste Reservestromversorgung (28) als Reaktion auf die Erkennung des Anzeigeanforderungssignals, wenn die Stromversorgung (24) keinen elektrischen Wechselstrom von der externen Stromquelle empfängt, Vorstrom für die Anzeige (22) bereitstellt, umfaßt.

15. Verfahren nach Anspruch 14, weiterhin mit einem Schritt des Einsetzens einer zweiten Reservestromversorgung (30) zur Bereitstellung von Vorstrom für den Prozessor (18), wenn die Stromversorgung (24) keinen elektrischen Wechselstrom von der externen Stromquelle empfängt.

16. Verfahren nach Anspruch 14, weiterhin mit einem Schritt des Einsetzens einer Batterie zur Bereitstellung von Vorstrom für den Prozessor (18), wenn die Stromversorgung (24) keinen elektrischen Wechselstrom von der externen Stromquelle empfängt.

17. Verfahren nach Anspruch 11, wobei der elektronische Verbrauchszähler (10) weiterhin eine Batterie enthält und der Schritt d) weiterhin das Bewirken, daß die Batterie als Reaktion auf die Erkennung des Anzeigeanforderungssignals, wenn die Stromversorgung (24) keinen elektrischen Wechselstrom von der externen Stromquelle empfängt, mit der Anzeige (22) verbunden wird, umfaßt.

18. Anordnung zum Anzeigen von Informationen in einem an ein elektrisches System einer Einrichtung angekoppelten elektronischen Verbrauchszähler (10) mit folgendem:
a) einer Stromversorgung (24) zur Umwandlung von von einer elektrischen Stromquelle empfangenem elektrischem Wechselstrom in Vorstrom;
b) einer funktionsmäßig zum Empfangen von Vorstrom von der Stromversorgung (24) gekoppelten Anzeige (22);
c) einer ersten Reservestromversorgung (28) zur Erzeugung von Vorstrom;
d) einem Prozessor (18) zur Bereitstellung von Vorstrom für die Anzeige (22), wenn die Stromversorgung (24) elektrischen Wechselstrom von der externen Stromversorgung (24) empfängt, und
zum Feststellen, ob die Stromversorgung (24) keinen elektrischen Wechselstrom von der externen Stromquelle empfängt;
Erkennen eines vom Bediener aktivierten Anzeigeanforderungssignals, wenn die Stromversorgung (24) keinen elektrischen Wechselstrom von der externen Stromquelle empfängt; und
Bewirken, daß die Reservestromversorgung (28) als Reaktion auf das Erkennen des vom Bediener aktivierten Anzeigeanforderungssignals, wenn die Stromversorgung (24) keinen elektrischen Wechselstrom von der externen Stromquelle empfängt, Vorstrom für die Anzeige (22) bereitstellt.

19. Anordnung nach Anspruch 18, wobei der Prozessor (18) weiterhin bewirkt, daß die erste Reservestromversorgung (28) keinen Vorstrom für die Anzeige (22) bereitstellt, wenn die Stromversorgung (24) elektrischen Wechselstrom von der externen Stromquelle empfängt.

20. Anordnung nach Anspruch 18, wobei die Stromversorgung (24) die Umwandlung von von der externen Stromquelle empfangenem elektrischen Wechselstrom in Vorstrom bewirkt, wobei die externe Stromquelle das Stromnetz ist.

21. Anordnung nach Anspruch 18, weiterhin mit einer zweiten Reservestromversorgung (30) zur Bereitstellung von Vorstrom für den Prozessor (18), wenn die Stromversorgung (24) keinen elektrischen Wechselstrom von der externen Stromquelle empfängt.

22. Anordnung nach Anspruch 21, wobei die zweite Reservestromversorgung (24) eine interne elektrische Stromquelle im elektronischen Verbrauchszähler (10) enthält.

23. Anordnung nach Anspruch 22, wobei die elektrische Stromquelle mindestens eine Batterie umfaßt.

24. Anordnung nach Anspruch 18, wobei die erste Reservestromversorgung (28) eine interne elektrische Stromquelle im elektronischen Verbrauchszähler (10) enthält.

25. Anordnung nach Anspruch 24, wobei die elektrische Stromquelle mindestens eine Batterie umfaßt.

26. Anordnung nach Anspruch 18, weiterhin mit einem an den Prozessor (18) angekoppelten Druckknopf (50) zur Erzeugung des Anzeigeanforderungssignals.

27. Anordnung nach Anspruch 18, weiterhin mit einer Stromausfallerkennungsschaltung (26) zur Bereitstellung eines eine Unterbrechung des elektrischen Wechselstroms zur Stromversorgung (24) anzeigenden Stromausfallsignals, wobei der Prozessor (18) weiterhin als Reaktion auf das Stromausfallsignal bestimmen kann, wann die Stromversorgung (24) keinen elektrischen Wechselstrom von der externen Quelle empfängt.

28. An ein elektrisches System einer Einrichtung angekoppelter elektronischer Verbrauchszähler (10) mit folgendem:
a) einer Quelle von Energieverbrauchsinformationen (16) ;
b) einer Anzeige (22);
c) einer Stromversorgung (24) zum Umwandeln von von einer externen Stromquelle empfangenem elektrischen Wechselstrom in Vorstrom;
d) einem an die Quelle von Energieverbrauchsinformationen (16) zum Empfangen von Ressourcenverbrauchsinformationen von dieser angekoppelten Prozessor (18) zum Erzeugen von Zählerstandsinformationen mindestens teilweise auf Grundlage der Ressourcenverbrauchsinformationen;
Bewirken einer Anzeige einer ersten Menge von Zählerstandsinformationen, wenn die Stromversorgung (24) elektrischen Wechselstrom von der externen Stromquelle empfängt;
Feststellen, ob die Stromversorgung (24) keinen elektrischen Wechselstrom von der externen Stromquelle empfängt;
Erkennen eines vom Bediener aktivierten Anzeigeanforderungssignals, wenn die Stromversorgung (24) keinen elektrischen Wechselstrom von der externen Stromquelle empfängt; und
Bewirken einer Anzeige einer zweiten Menge der Zählerstandsinformationen als Reaktion auf die Erkennung des Anzeigeanforderungssignals, wenn die Stromversorgung (24) keinen elektrischen Wechselstrom von der externen Stromquelle empfängt.

29. Elektronischer Verbrauchszähler (10) nach Anspruch 28, wobei die Quelle von Ressourcenverbrauchsinformationen eine Quelle von Energieverbrauchsinformationen (16) umfaßt und die Zählerstandsinformationen angesammelte Energieverbrauchsinformationen umfassen.

## Revendications

1. Compteur électronique de services (10) relié à un système électrique d'une installation, le compteur électronique de services (10) comprenant :
a) une source d'informations de consommation d'énergie (16);
b) un afficheur (22) ;
c) une alimentation électrique (24) pouvant être mise en fonctionnement pour convertir une énergie électrique à courant alternatif reçue d'une source d'alimentation électrique en une alimentation de polarisation ;
d) un processeur (18) relié à la source d'informations de consommation d'énergie (16) pour recevoir de celle-ci des informations de consommation d'énergie, ledit processeur (18) ayant pour fonction de :
produire des informations de comptage dépendant au moins en partie des informations de consommation d'énergie ;
provoquer l'affichage d'un premier ensemble d'informations de comptage lorsque l'alimentation électrique (24) reçoit une énergie électrique à courant alternatif de la source d'énergie externe ;
déterminer si oui ou non l'alimentation électrique (24) ne reçoit pas d'énergie électrique à courant alternatif de la source d'énergie externe ;
détecter un signal de demande d'affichage activé par un opérateur lorsque l'alimentation électrique (24) ne reçoit pas d'énergie électrique à courant alternatif de la source d'énergie externe ; et
provoquer l'affichage d'un second ensemble d'informations de comptage en réponse à la détection du signal de demande d'affichage lorsque l'alimentation électrique (24) ne reçoit pas d'alimentation électrique à courant alternatif de la source d'énergie externe.

2. Compteur électronique de services (10) suivant la revendication 1, dans lequel l'alimentation électrique (24) a pour fonction de convertir une énergie électrique à courant alternatif reçue de la source d'énergie externe en une alimentation de polarisation, la source d'énergie externe étant le système électrique.

3. Compteur électronique de services (10) suivant la revendication 1, comprenant en outre une première alimentation électrique de secours (28) ayant pour fonction de fournir une alimentation de polarisation à l'afficheur (22) et dans lequel le processeur (18) a en outre pour fonction de faire en sorte que l'alimentation électrique de secours (28) fournisse une alimentation de polarisation à l'afficheur (22) en réponse à la détection du signal de demande d'affichage lorsque l'alimentation électrique (24) ne reçoit pas d'énergie électrique à courant alternatif de la source d'énergie externe.

4. Compteur électronique de services (10) suivant la revendication 3, comprenant en outre une secondé alimentation électrique de secours (30) ayant pour fonction de fournir une alimentation de polarisation au processeur (18) lorsque l'alimentation électrique (24) ne reçoit pas d'énergie électrique à courant alternatif de la source d'énergie externe,

5. Compteur électronique de services (10) suivant la revendication 4, dans lequel la seconde alimentation électrique de secours (30) comporte une source d'énergie électrique interne au compteur électronique de services (10).

6. Compteur électronique de services (10) suivant la revendication 5, dans lequel la seconde alimentation électrique (30) comprend au moins une batterie.

7. Compteur électronique de services (10) suivant la revendication 3, dans lequel la seconde alimentation électrique de secours (30) comporte une source d'énergie électrique interne au compteur électronique de services (10).

8. Compteur électronique de services (10) suivant la revendication 7, dans lequel la source d'énergie électrique (28) comprend au moins une batterie.

9. Compteur électronique de services (10) suivant la revendication 1, comprenant en outre un bouton-poussoir (50) relié au processeur (18), et dans lequel le bouton poussoir (50) a pour fonction de produire le signal de demande d'affichage.

10. Compteur électronique de services (10) suivant la revendication 1, comprenant en outre un circuit de détection de panne d'alimentation (26) ayant pour fonction de fournir un signal de panne d'alimentation représentatif d'une interruption de l'énergie électrique à courant alternatif fournie à l'alimentation électrique (24), et dans lequel le processeur (18) a en outre pour fonction de déterminer l'instant où l'alimentation électrique (24) ne reçoit pas d'énergie électrique à courant alternatif de la source externe en réponse au signal de panne d'alimentation.

11. Procédé de mise en fonctionnement d'un compteur électronique de services (10) qui comporte une alimentation électrique (24) convertissant de l'énergie électrique à courant alternatif reçue d'une source externe en alimentation de polarisation, d'où il résulte que lorsque l'alimentation électrique (24) reçoit de l'énergie électrique à courant alternatif de la source d'énergie externe, un premier ensemble d'informations de comptage est affiché et, pendant une interruption de l'énergie électrique à courant alternatif, celui-ci comprend les étapes consistant à :
a) recevoir des informations de consommation d'énergie dans un processeur (18) et produire à partir de celles-ci des informations de comptage;
b) déterminer si oui ou non l'alimentation électrique (24) ne reçoit pas d'énergie électrique à courant alternatif de la source externe ;
c) détecter un signal de demande d'affichage produit par un opérateur lorsque l'alimentation électrique (24) ne reçoit pas d'énergie électrique à courant alternatif de la source externe ; et
d) provoquer l'affichage par un afficheur de compteur (22) d'au moins certaines des informations de comptage en réponse à la détection du signal de demande d'affichage lorsque l'alimentation électrique (24) ne reçoit pas d'énergie électrique à courant alternatif de la source externe.

12. Procédé suivant la revendication 11, dans lequel l'étape b) consiste en outre à comparer une sortie de l'alimentation électrique (24) à une tension de référence interne, et à déterminer si oui ou non l'alimentation électrique (24) ne reçoit pas d'énergie électrique à courant alternatif de la source externe sur la base de cette comparaison.

13. Procédé suivant la revendication 11, dans lequel l'étape c) consiste en outre à détecter un signal de demande d'affichage produit par un opérateur en détectant l'état d'un bouton-poussoir (50) situé sur le compteur électronique de services (10).

14. Procédé suivant la revendication 11, dans lequel le compteur électronique de services (10) comporte en outre une première alimentation électrique de secours (28) et dans lequel l'étape d) consiste en outre à faire en sorte que la première alimentation électrique de secours (28) fournisse une alimentation de polarisation à l'afficheur (22) en réponse à la détection du signal de demande d'affichage lorsque l'alimentation électrique (24) ne reçoit pas d'énergie électrique à courant alternatif de la source d'énergie externe.

15. Procédé suivant la revendication 14, comprenant en outre l'étape consistant à utiliser une seconde alimentation électrique de secours (30) pour fournir de l'énergie de polarisation au processeur (18) lorsque l'alimentation électrique (24) ne reçoit pas d'énergie électrique à courant alternatif de la source d'énergie externe.

16. Procédé suivant la revendication 14, comprenant en outre l'étape consistant à utiliser une batterie pour fournir une alimentation de polarisation au processeur (18) lorsque l'alimentation électrique (24) ne reçoit pas d'énergie électrique à courant alternatif de la source d'énergie externe.

17. Procédé suivant la revendication 11, dans lequel le compteur électronique de services (10) comporte en outre une batterie et dans lequel l'étape (d) consiste en outre à faire en sorte que la batterie soit connectée à l'afficheur (22) en réponse à la détection du signal de demande d'affichage lorsque l'alimentation électrique (24) ne reçoit pas d'énergie électrique à courant alternatif de la source d'énergie externe.

18. Système destiné à afficher des informations dans un compteur électronique de services (10) relié à un système électrique d'une installation, le système comprenant :
a) une alimentation électrique (24) ayant pour fonction de convertir de l'énergie électrique à courant alternatif reçue d'une source d'énergie externe en une alimentation de polarisation ;
b) un afficheur (22) fonctionnellement relié de façon à recevoir une alimentation de polarisation de l'alimentation électrique (24) ;
c) une première alimentation électrique de secours (28) ayant pour fonction de produire une alimentation de polarisation ;
d) un processeur (18) ayant pour fonction de fournir une alimentation de polarisation à l'afficheur (22) lorsque l'alimentation électrique (24) reçoit de l'énergie électrique à courant alternatif de l'alimentation électrique externe (24), et de
déterminer si oui ou non l'alimentation électrique (24) ne reçoit pas d'énergie électrique à courant alternatif de la source d'énergie externe ;
détecter un signal de demande d'affichage activé par un opérateur lorsque l'alimentation électrique (24) ne reçoit pas d'énergie électrique à courant alternatif de la source d'alimentation externe ; et
provoquer la fourniture par l'alimentation électrique de secours (28) d'une alimentation de polarisation à l'afficheur (22) en réponse à la détection du signal de demande d'affichage activé par un opérateur lorsque l'alimentation électrique (24) ne reçoit pas d'énergie électrique à courant alternatif de la source d'énergie externe.

19. Système suivant la revendication 18, dans lequel le processeur (18) a en outre pour fonction de faire en sorte que la première alimentation électrique de secours (28) ne fournisse pas d'alimentation de polarisation à l'afficheur (22) lorsque l'alimentation électrique (24) reçoit de l'énergie électrique à courant alternatif de la source d'énergie externe.

20. Système suivant la revendication 18, dans lequel l'alimentation électrique (24) a pour fonction de convertir une énergie électrique à courant alternatif reçue de la source d'énergie externe en une alimentation de polarisation, la source d'énergie externe étant le système électrique.

21. Système suivant la revendication 18, comprenant en outre une seconde alimentation électrique de secours (30) ayant pour fonction de fournir une énergie de polarisation au processeur (18) lorsque l'alimentation électrique (24) ne reçoit pas d'énergie électrique à courant alternatif de la source d'énergie externe,

22. Système suivant la revendication 21, dans lequel la seconde alimentation électrique de secours comporte une source d'énergie électrique interne au compteur électronique de services (10).

23. Système suivant la revendication 22, dans lequel la source d'énergie électrique comprend au moins une batterie.

24. Système suivant la revendication 18, dans lequel la première alimentation électrique de secours (28) comporte une source d'énergie électrique interne au compteur électronique de services (10).

25. Système suivant la revendication 24, dans lequel la source d'énergie électrique comprend au moins une batterie.

26. Système suivant la revendication 18, comprenant en outre un bouton-poussoir (50) relié au processeur (18) et dans lequel le bouton poussoir (50) a pour fonction de produire le signal de demande d'affichage.

27. Système suivant la revendication 18, comprenant en outre un circuit de détection de panne d'alimentation (26) ayant pour fonction de fournir un signal de panne d'alimentation représentatif d'une interruption de l'énergie électrique à courant alternatif fournie à l'alimentation électrique (24), et dans lequel le processeur (18) a en outre pour fonction de déterminer l'instant où l'alimentation électrique (24) ne reçoit pas d'énergie électrique à courant altematif de la source externe en réponse au signal de panne d'alimentation.

28. Compteur électronique de services (10) relié à un système électrique d'une installation, le compteur électronique de services (10) comprenant :
a) une source d'informations de consommation d'énergie (16);
b) un afficheur (22);
c) une alimentation électrique (24) ayant pour fonction de convertir une énergie électrique à courant alternatif reçue d'une source d'énergie externe en une alimentation de polarisation ;
d) un processeur (18) relié à la source d'informations de consommation d'énergie (16) pour recevoir de celle-ci des informations de consommation d'énergie, le processeur (18) ayant pour fonction de
produire des informations de comptage dépendant au moins en partie des informations de consommation de ressources ;
provoquer l'affichage d'un premier ensemble d'informations de comptage lorsque l'alimentation électrique (24) reçoit de l'énergie électrique à courant alternatif de la source d'énergie externe ;
déterminer si oui ou non l'alimentation électrique (24) ne reçoit pas d'énergie électrique à courant alternatif de la source d'énergie externe ;
détecter un signal de demande d'affichage activé par un opérateur lorsque l'alimentation électrique (24) ne reçoit pas d'énergie électrique à courant alternatif de la source d'énergie externe ; et
provoquer l'affichage d'un second ensemble d'informations de comptage en réponse à la détection du signal de demande d'affichage lorsque l'alimentation électrique (24) ne reçoit pas d'énergie électrique à courant alternatif de la source d'énergie externe.

29. Compteur électronique de services (10) suivant la revendication 28, dans lequel la source d'informations de consommation de ressources comporte une source d'informations de consommation d'énergie (16), et dans lequel les informations de comptage comprennent des informations de consommation d'énergie accumulées.
